# EUROPÄISCHE PATENTSCHRIFT

(11) **EP 2 943 043 B1**
(45) Veröffentlichungstag und Bekanntmachung des Hinweises auf die Patenterteilung: **19.04.2017**
(21) Anmeldenummer: 15001362.1
(22) Anmeldetag: 07.05.2015
(51) Int. Cl.: H05B 3/26, H05K 1/11, H05B 1/02, H05B 3/34, H05K 1/02

(54) **HEIZEINRICHTUNG ZUM BEHEIZEN VON FLÄCHEN IM INNENRAUM EINES FAHRZEUGS**
HEATING DEVICE FOR HEATING AREAS IN THE PASSENGER COMPARTMENT OF A VEHICLE
DISPOSITIF DE CHAUFFAGE DE SURFACES DANS L'HABITACLE D'UN VÉHICULE

(30) Priorität: 08.05.2014 DE 202014003827 U
(43) Veröffentlichungstag der Anmeldung: 11.11.2015
(73) Patentinhaber: I.G. Bauerhin GmbH, 63584 Gründau (DE)
(72) Erfinder: Lochmann, Karl, 63584 Gründau (DE); Barthel, Dieter, 63517 Rodenbach (DE)
(74) Vertreter: Grimm, Ekkehard

(56) Entgegenhaltungen:
- WO-A1-90/10999
- US-A- 5 811 760
- US-A1- 2009 001 778
- US-A1- 2013 277 352

## Beschreibung

Die vorliegende Erfindung betrifft eine Heizeinrichtung gemäß dem Oberbegriff des Anspruchs 1; eine solche Heizeinrichtung ist aus der WO/90/10999 A1 bekannt. Eine solche Heizeinrichtung mit einer dieser zugeordneten Temperaturerfassung dient zum Beheizen von Flächen im Innenraum eines Fahrzeugs. Sie umfasst mindestens ein Heizelement, das mindestens einen Heizleiter, der einen elektrischen Heizkreis bildet, und mindestens ein Trägermaterial aufweist, wobei der Heizleiter durch das Trägermaterial gehalten ist. Weiterhin ist ein Temperaturerfassungselement vorhanden. Der Heizleiter weist mindestens zwei Heizleiter-Anschlussenden (HL-Anschlussenden) auf und das Temperaturerfassungselement weist mindestens zwei Temperaturerfassungselement-Anschlussenden (TE-Anschlussenden) auf. Soweit in den Ansprüchen und der Beschreibung die Abkürzung HL verwendet wird, so steht diese für "Heizleiter", während die Abkürzung TE für "Temperaturerfassungselement" steht.

Solche Heizeinrichtungen werden zum Beheizen von Flächen im Innenraum von Fahrzeugen eingesetzt, wie beispielsweise zum Beheizen von Lenkrädern, Sitzen, Türverkleidungen, Armlehnen, Fußmatten, letztendlich zum Beheizen von allen möglichen benutzerberührbaren Flächen innerhalb des Fahrzeugs.

In der Regel weisen solche Heizeinrichtungen ein Temperaturerfassungselement auf, um die Temperatur im Bereich der Heizung zu erfassen. Folglich besitzt eine solche Heizeinrichtung neben den Anschlussenden für den Heizleiter, auch Anschlussenden für das Temperaturerfassungselement. Diese Anschlussteile müssen so gestaltet sein, dass sie einen einfachen, gut zugänglichen Anschluss ermöglichen.

Drähte, die als Heizleiter oder als Zuleitung der Temperaturerfassungseinrichtung dienen, werden im Anschlussbereich mit Drähten der Anschlussleiter verdrillt, verlötet und beispielsweise mittels Schrumpfschlauch isoliert und in vielen Fällen weiterhin mittels Kleber und/oder mittels Abdeckungen zur Zugentlastung gesichert. Dieser Vorgang ist aufwändig, und insbesondere ist die Positionierung der Lötverbindungen, wenn überhaupt, nur schwer reproduzierbar.

Die WO 90/10999 A1 beschreibt eine Heizeinrichtung zum Beheizen eines Sitzes mit einer elektrischen Heizeinrichtung, die in den Sitz eingebettet ist, und mit einer auf die Temperatur ansprechenden Einrichtung (Temperatursensor) sowie mit einer Kontrolleinrichtung zum Steuern der Zufuhr elektrischen Stroms zu der Heizeinrichtung, die ebenso in den Sitz eingebettet ist. Sowohl die Temperaturerfassungseinrichtung als auch die Kontrolleinrichtung sind an einer flexiblen Leiterplatte befestigt, die in den Sitz eingebettet ist. Die Leiterplatte ist mit einer Vielzahl diskreter Bauteile bestückt. Außerdem sind Anschlussflächen vorhanden, an denen der Temperatursensor und zumindest ein Anschlussdraht der Heizung befestigt sind. Die Leiterplatte ist im Bereich des Verlaufs des Heizdrahts angeordnet.

Die US 2009/001778 A1 beschreibt einen Fahrzeugsitz mit einer Sitzfläche, die in einer Vielzahl von Zonen unterteilt ist, die in der Temperatur eingestellt werden können. Mindestens eine elektrisch betätigte Heiz/Kühlquelle dient zum Erwärmen und Kühlen der verschiedenen Zonen. Eine Steuereinrichtung steuert die elektrische Energie, die von der Quelle zu jeder Zone zugeführt wird, und dient insbesondere dazu, den Energieverbrauch in einer Zone relativ zu einer anderen Zone entsprechend einem vorgegebenen Profil zu verringern.

Der vorliegenden Erfindung liegt die Aufgabe zugrunde, eine Heizeinrichtung der eingangs genannten Art so auszugestalten, dass die Anbindung des Heizelements mit seinen Anschlüssen an die Zuleitung reproduzierbar gestaltet werden kann, und darüber hinaus die Möglichkeit besteht, dass das Temperaturerfassungselement thermisch definiert an den Heizleiter gekoppelt werden kann.

Gelöst wird diese Aufgabe durch eine Heizeinrichtung mit den Merkmalen des Anspruchs 1. Bevorzugte Ausführungsformen ergeben sich aus den abhängigen Ansprüchen.

Die erfindungsgemäße Heizeinrichtung zeichnet sich dadurch aus, dass mindestens die zwei HL-Anschlussenden (1a, 1b) mit jeweils einer ersten HL-Anschlussfläche (2) der Leiterplatte (7) elektrisch verbunden sind und die zwei TE-Anschlussenden (4a, 4b) mit jeweils einer ersten TE-Anschlussfläche (5) der Leiterplatte (7) elektrisch verbunden sind, und die Leiterplatte (7) zwei zweite HL-Anschlussflächen (10) und mindestens eine zweite TE-Anschlussfläche (11) aufweist, wobei die ersten HL-Anschlussflächen (2) und die zweiten HL-Anschlussflächen (10) zumindest teilweise mittels erster Leiterbahnen (12) und die eine erste TE-Anschlussfläche (5) und/oder die andere der zwei ersten TE-Anschlussflächen (5) jeweils mittels einer zweiten Leiterbahn (13) mit einer zweiten TE-Anschlussfläche (11) verbunden sind.

Über die auf der Leiterplatte angeordneten Anschlussflächen, das bedeutet die HL-Anschlussflächen (Heizleiter-Anschlussflächen) und die TE-Anschlussflächen (Temperaturerfassungselement-Anschlussflächen), werden sowohl das Heizelement als auch das Temperaturerfassungselement mit einer Elektronik oder Auswerteeinheit verbunden. Dieser Vorgang kann zumindest teilweise gerade dadurch, dass sich diese Anschlussflächen auf der Leiterplatte, die vorzugsweise sehr klein dimensioniert ist, automatisiert durchgeführt werden. Diese Anschlussflächen sind auf der Leiterplatte fest vorgegeben, wodurch die Arbeitsgänge reproduzierbar und automatisierbar sind.

Falls die Heizeinrichtung beispielsweise für ein Lenkrad vorgesehen ist, wird die Leiterplatte an einem geeigneten Bereich, beispielsweise des Lenkradkranzes oder der Lenkradnabe, positioniert. Vor dem Positionieren und Verbinden der Anschlussenden für den Heizleiter des Heizelements (HL-Anschlussenden) und den Anschlussenden für das Temperaturerfassungselement (TE-Anschlussenden) mit den entsprechenden auf der Leiterplatte angeordneten Anschlussflächen (erste HL-Anschlussflächen und erste TE-Anschlussflächen) werden im Vorfeld an den anderen Enden der Leiterbahnen, also an den zweiten HL-Anschlussflächen und zweiten TE-Anschlussflächen, die Verbindungen mit der Stromversorgung für den Heizleiter und die elektrischen Verbindungen zu dem Temperaturerfassungselement und/oder Verbindungen mit einer Elektronik oder Auswerteeinheit befestigt. Diese Befestigung an den Anschlussflächen kann, beispielsweise durch einen Löt-, Crimp-, Schweiß- oder Klebevorgang, vorgenommen werden. Für den zuletzt genannten Verbindungsvorgang durch Kleben sollte ein elektrisch leitfähiger Kleber eingesetzt werden.

Es ist vorgesehen, dass eine solche Leiterplatte beispielsweise mit Teilen des Lenkrads über eine Steck- oder auch Clip-Verbindung verbunden wird. Es besteht die Möglichkeit, die Leiterplatte in einer derart kleinen Baugröße zu dimensionieren, dass diese in einer Lenkradspeiche eines Lenkradrohlings, und dort vorzugsweise in einer entsprechend angepassten Vertiefung, angeordnet werden kann. Dort können dann die Anschlussenden des Heizelements bzw. des Heizleiters und die Anschlussenden des Temperaturerfassungselements mit den entsprechenden Anschlussflächen der Leiterbahnen, die dazu zugeordnet sind, verbunden werden.

Die Leiterplatte kann in ihrer Geometrie den Gegebenheiten angepasst werden, indem eine rechteckige oder quadratische Form verwendet wird. Die Ecken können abgerundet werden; es ist aber auch eine ovale oder Trapezform, in Draufsicht auf die Leiterplatte gesehen, vorgesehen.

Die erfindungsgemäße Heizeinrichtung mit Heizleiter und Temperaturerfassungselement eignet sich insbesondere zum Beheizen von kleinen Flächenbereichen im Innenraum eines Fahrzeugs dort, wo nur ein begrenzter Raum für die Installation der Verbindungselemente, die dem Heizleiter und dem Temperaturerfassungselement zugeordnet sind, zur Verfügung steht. Daher ist diese Heizeinrichtung neben der Beheizung eines Lenkrads auch für die Beheizung eines Schaltknaufs, eines Gangwählhebels, einer Armlehne, eines Haltegriffs besonders gut geeignet. Weiterhin ist vorgesehen, eine solche Heizeinrichtung für Verkleidungselemente, beispielsweise der Tür oder der Seitenteile eines Fahrzeugs, einzusetzen, nämlich dort, wo gerade für die Anschlussteile nur geringer Raum vorhanden ist.

Die Leiterplatte weist zumindest eine erste Anschlussfläche (erste HL-Anschlussfläche), die den Anschlussenden des Heizleiters des Heizelements zugeordnet sind, sowie mindestens eine erste Anschlussfläche (erstes TE-Anschlussfläche), die dem mindestens einen ersten Anschlussende des Temperaturerfassungselements zugeordnet ist, auf. Es können aber auch weitere, zusätzliche Anschlussflächen vorgesehen werden, die den weiteren Anschlussenden des Temperaturerfassungselements oder des Heizleiters zugeordnet sind.

Bevorzugt werden die einen Anschlussflächen, d. h. die ersten HL-Anschlussflächen und die ersten TE-Anschlussflächen, im Bereich einer Kante des elektrisch isolierenden Trägermaterials der Leiterplatte angeordnet; von dieser Kante aus verlaufen dann vorzugsweise die Leiterbahnen zu den anderen Anschlussflächen, d. h. den zweiten HL-Anschlussflächen und den zweiten TE-Anschlussflächen, an der gegenüber liegenden Kante der Leiterplatte.

Erfindungsgemäß verlaufen die Leiterbahn(en) für das Temperaturerfassungselement zwischen den Leiterbahnen für den Heizleiter des Heizelements.

Gerade in einer solchen Anordnung kann das Temperaturerfassungselement mit den beiden Leiterbahnen, die zwischen den Leiterbahnen für das Heizelement verlaufen, unmittelbar verbunden werden, d. h. ohne zusätzlichen Drähte zwischen dem Temperaturerfassungselement und den Anschlussenden der Leiterbahnen. Insbesondere in einer solchen Anordnung wird die von den Leiterbahnen des Heizelements ausgehende Wärme durch das Temperaturerfassungselement erfasst und davon abhängig wird die Temperatur bzw. Heizleistung des Heizelements eingestellt. Bei einer Anordnung des Temperaturerfassungselements unmittelbar auf der Leiterplatte ist eine Vorkonfektionierung der Leiterplatte mit einem Temperaturerfassungselement beispielsweise als SMD-Bauelement (surface-mounted-device (oberflächenmontiertes Bauelement)) möglich, und das Temperaturerfassungselement befindet sich reproduzierbar nach dem Einbau der Heizeinrichtung an identischer Stelle in fester Zuordnung zu dem Heizleiter bzw. dem Heizelement bzw. den dazu zugeordneten Leiterbahnen für die Auswerteeinheit/Elektronik des Heizelements.

Es ist auch vorgesehen, dass das Temperaturerfassungselement mit einem Wärmespeicher aus einem Wärme speichernden Material in Kontakt steht, um dadurch die Trägheit des Temperaturerfassungselements für die Temperaturregelung einzustellen. Ein solcher Wärmespeicher kann unmittelbar auf der Leiterplatte angeordnet werden, beispielsweise durch Aufbringung von Lötzinn oder durch ein SMD-Bauelement auf der Leiterplatte.

Die Leiterbahn(en) für das Temperaturerfassungselement sollten als Stege mit im Wesentlichen gleicher Breite ausgebildet werden, vorzugsweise als schmale Leiterbahnen mit einer Breite von jeweils 0,2 mm bis 1 mm, noch bevorzugter als schmale Leiterbahnen mit einer Breite von jeweils 0,2 mm bis 0,5 mm. Im Gegensatz dazu ist vorgesehen, dass die Breite jeder Leiterbahn für das Heizelement bzw. den Heizleiter mindestens das Vierfache der Breite einer Leiterbahn für das Temperaturerfassungselement beträgt. Die maximale Breite der Leiterbahnen für das Heizelement sollte im Bereich von jeweils 8 mm bis 15 mm betragen. Bevorzugt sollte die maximale Breite der Leiterbahnen für das Heizelement im Bereich von jeweils 8 mm bis 10 mm liegen.

Über die Geometrie und den Leiterbahnverlauf, den die jeweilige Leiterbahn auf der Leiterplatte einnimmt, und/oder über die Dicke der Leiterbahn kann der Leitungswiderstand der jeweiligen Leiterbahn eingestellt werden, um so die abgegebene Wärmeleistung einzustellen.

Die Abmessungen der Leiterplatte betragen bevorzugt in jeder Richtung maximal 30 mm. Die Abmessungen variieren bevorzugt von 10 mm bis 30 mm. Die Leiterplatte kann eine Dicke von 0,3 mm bis 5 mm aufweisen; dünnes Leiterplattenmaterial sollte dort eingesetzt werden, wo dünne, flexible Heizelemente bzw. Heizleiter eingesetzt werden und wo anpassungsfähige und wenig auftragende Materialien benötigt werden, wie beispielsweise im Lenkrad, während dickeres Material für die Leiterplatte dort zu verwenden ist, wo mechanische Stabilität und dadurch geringe Verwindung Priorität haben, wie beispielsweise in einem Fahrzeugsitz oder in Türverkleidungen. Es ist auch vorgesehen, eine flexible Leiterplatte dort einzusetzen, wo sie sich entsprechenden Flächen beim Einbau anpassen sollte.

Um die Übertragung von Wärme durch Wärmeleitung von den Leiterbahnen der Leiterplatte, die dem Heizleiter zugeordnet sind, beispielsweise auf ein Temperaturerfassungselement, das ebenfalls auf der Leiterplatte angeordnet ist, einzustellen, wird im Bereich des Temperaturerfassungselements zwischen der jeweiligen Leiterbahn für das Temperaturerfassungselement und der jeweils benachbarten Leiterbahn für das Heizelement bzw. den Heizleiter Material der Trägerplatte abgetragen oder die Leiterplatte wird in diesem Bereich mit einer Durchbrechung versehen. Über den Umfang des Materialabtrags an der Leiterplatte kann die Wärmeleitung von den Leiterbahnen des Heizkreises zu dem Temperaturerfassungselement eingestellt werden. Eine Durchbrechung der Trägerplatte, wobei eine solche Durchbrechung auch als Einschnitt bezeichnet werden kann, sollte eine Breite, in der Ebene der Trägerplatte gesehen, von 0,3 bis 3 mm, 1,5 bis 2,5 mm, bevorzugt von etwa 2 mm, aufweisen. Auch kann diese thermische Kopplung über die Wahl des Materials der Leiterplatte eingestellt werden.

Die Verbindungen der Anschlussenden von Zuleitungen und die Verbindung des Heizleiters und der Anschlussenden des Temperaturerfassungselements mit den jeweils dazu zugeordneten Anschlussflächen der Leiterplatte können gelötet, gecrimpt, geschweißt oder auch verklebt werden, letzteres bevorzugt mittels leitfähigem Klebemittel. Die Dicke der Leiterbahnen, senkrecht zur Ebene der Leiterplatte, liegt im Bereich von 30 µm - 70 µm. Wie bereits erwähnt kann über die Geometrie und/oder dem Verlauf der Leiterbahn deren Widerstand eingestellt werden. Mit größerer Fläche und größerer Dicke (größerer Querschnittsfläche) wird der Widerstand verkleinert und somit die Wärmeentwicklung längs der Leiterbahn des Heizleiters geringer. Die Leiterbahnen für das Temperaturerfassungselement können im Verhältnis zu der Leiterbahn des Heizkreises dünn und schmal ausgeführt werden, beispielsweise mit Querschnittsabmessungen von 0,2 mm (Materialbreite) x 30 µm (Materialdicke).

Je dünner bzw. schmaler die Leiterbahnen für das Temperaturerfassungselement ausgebildet werden umso weniger Störungen ergeben sich für das Temperaturerfassungselement durch die über diese Leiterbahnen erzeugte Wärmemenge.

Die Erfindung kann auch dadurch beschrieben werden, dass sie auf eine Heizeinrichtung mit Temperaturerfassung zum Beheizen von Flächen im Innenraum eines Fahrzeugs mit mindestens einem Heizelement, das mindestens einen Heizkreis umfasst, und mit einem Temperaturerfassungselement gerichtet ist. Das Heizelement weist mindestens zwei Anschlussenden auf, die über Anschlussleiter mit einer Stromversorgung verbindbar sind. Das Temperaturerfassungselement weist zwei Kontaktenden auf, wobei mindestens eines dieser Kontaktenden über einen Verbindungsleiter mit einer Elektronik (Auswerteeinheit) verbindbar ist. Zwischen den Anschlussenden und den jeweils dazu zugeordneten Anschlussleitern des Heizelements und zwischen dem mindestens einen Kontaktende und dem dazu zugeordneten Verbindungsleiter des Temperaturerfassungselements ist jeweils eine Leiterbahn angeordnet ist, die Teil einer Leiterbahnenstruktur einer elektrisch isolierenden Trägerplatte bzw. Leiterplatte sind.

Soweit in der Beschreibung das Heizelement erwähnt ist, so umfasst dieses Heizelement mindestens ein Trägermaterial, mit dem ein Heizleiter verbunden ist. Dieser eine Heizleiter bildet zwischen seinen Anschlussenden einen Heizkreis. An dem Trägermaterial können aber auch mehrere Heizleiter angeordnet werden, wobei jeder dieser Heizleiter einen eigenständigen Heizkreis bilden kann.

Weitere Einzelheiten und Merkmale der Erfindung ergeben sich aus der nachfolgenden Beschreibung anhand der Zeichnung. In der Zeichnung zeigt
- Figur 1A: eine Heizeinrichtung gemäß der Erfindung in einer vergrößerten schematischen Draufsicht,
- Figur 1B: eine weitere Ausgestaltungsform der erfindungsgemäßen Heizeinrichtung in einer schematischen Darstellung,
- Figur 2: eine Leiterplatte in einer Draufsicht mit Temperaturerfassungselement als Bestückungsteil der Leiterplatte und mit einem dem Temperaturerfassungselement zugeordneten Wärmespeicher und mit zumindest teilweise mäanderförmig verlaufenden Leiterbahnen,
- Figur 3: eine Leiterplatte ähnlich der Figur 2 mit zusätzlichen Durchbrechungen im Bereich des Temperaturerfassungselements,
- Figur 4: eine der Figur 3 entsprechende Darstellung der Leiterplatte mit Durchbrechungen, die gegenüber Figur 3 länger ausgeführt sind, in einer Draufsicht,
- Figur 5: die Leiterplatte der Figur 4 mit Leiterbahnen für das Heizelement, die in der Fläche gegenüber denjenigen der Figur 4 vergrößert sind, und
- Figur 6: eine Ausführungsform, bei der die eine Leiterbahn, die dem Temperaturerfassungselement zugeordnet ist, mit der einen Leiterbahn für das Heizelement verbunden ist.

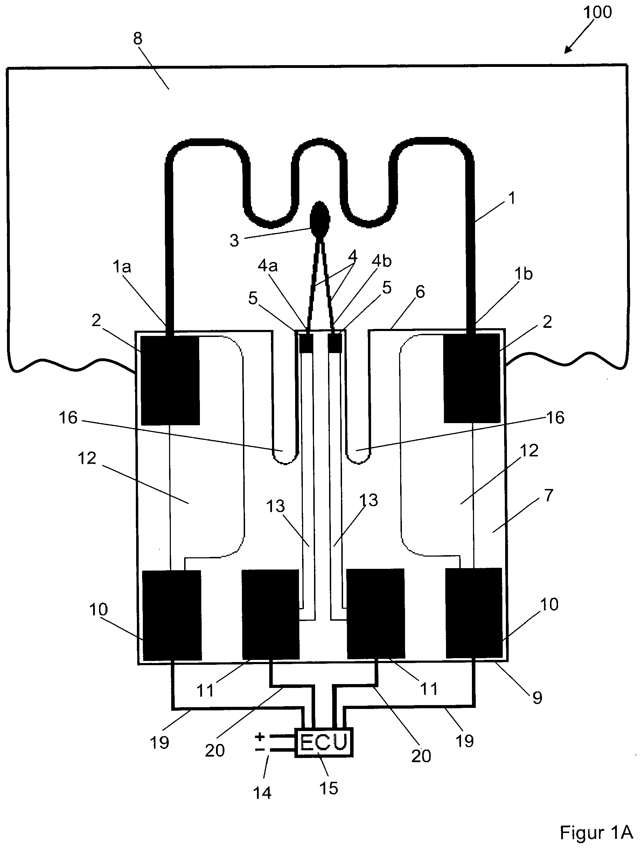

Die Heizeinrichtung, wie sie in Figur 1A dargestellt ist, umfasst ein Heizelement 100 mit einem Heizkreis in Form eines einzelnen Heizleiters 1, der mit seinen zwei HL-Anschlussenden (Heizleiter-Anschlussenden) 1a, 1b an zwei HL-Anschlussflächen (Heizleiter-Anschlussflächen) 2 einer Leiterplatte 7 verbunden ist, sowie ein Temperaturerfassungselement 3, das zwei TE-Anschlussenden (Temperaturerfassungselement-Anschlussenden) 4a, 4b aufweist, die mit zwei ersten TE-Anschlussflächen (Temperaturerfassungselement-Anschlussflächen) 5 der Leiterplatte 7 verbunden sind.

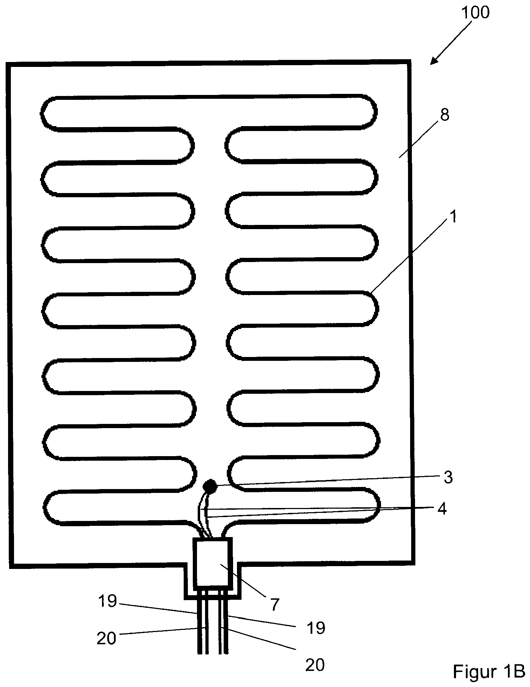

Diese ersten TE-Anschlussflächen 5 für das Temperaturerfassungselement 3 und die ersten HL-Anschlussflächen 2 für den Heizleiter 1 des Heizelements 100 sind auf einer Seite, mit dem Bezugszeichen 6 bezeichnet, der Leiterplatte 7 angeordnet. Diese Leiterplatte 7 ist in den Figuren, insbesondere in Figur 1, stark vergrößert dargestellt. Auf der anderen Seite dieser Leiterplatte 7, die der Seite 6 mit den ersten HL-Anschlussflächen 2 und den ersten TE-Anschlussflächen 5 gegenüber liegt, die mit dem Bezugszeichen 9 bezeichnet ist, befinden sich vier weitere Anschlussflächen, wobei jeweils zwei dieser Anschlussflächen, mit dem Bezugszeichen 10 bezeichnet, dem Heizleiter 1 (zweite HL-Anschlussfläche 10) zugeordnet sind, während die anderen zwei dieser Anschlussflächen, mit dem Bezugszeichen 11 bezeichnet, dem Temperaturerfassungselement 3 (zweite TE-Anschlussflächen 11) zugeordnet sind.

Zwischen den ersten HL-Anschlussflächen 2 und den zweiten HL-Anschlussflächen 10 und zwischen den ersten TE-Anschlussflächen 5 und den zweiten TE-Anschlussflächen 11 erstreckt sich jeweils eine Leiterbahn 12, 13, so dass die Anschlussflächen 2 und 5 jeweils mit den dazu zugeordneten Anschlussflächen 10 und 11 elektrisch verbunden sind. Die beiden zweiten HL-Anschlussflächen 10 sind elektrisch mit einer Elektronik oder Auswerteeinheit 15 (ECU - Electronic Control Unit) für den Heizleiter 1 des Heizelements 100 über Anschlussleiter 19 verbunden, während die beiden zweiten TE-Anschlussflächen 11, die dem Temperaturerfassungselement 3 zugeordnet sind, mit der Elektronik oder Auswerteeinheit 15 (ECU) über Verbindungsleiter 20 verbunden sind.

Die Leiterplatte 7 weist eine etwa quadratische Form auf mit einer Seitenlänge von bevorzugt etwa 30 mm; die Abmessungen können im Bereich von 15 mm bis 40 mm variieren. Die Dicke der Leiterplatte 7 liegt im Bereich von 0,5 mm bis 2 mm.

Um die Heizeinrichtung zum Beheizen einer Fläche im Innenraum eines Fahrzeugs einzubauen und sowohl den Heizleiter 1 als auch das Temperaturerfassungselement 3 elektrisch mit der Elektronik oder Auswerteeinheit 15 (ECU) zu verbinden, wird die Leiterplatte 7 an geeigneter Stelle im Bereich der zu beheizenden Fläche positioniert, wobei an den ersten Anschlussflächen 2 bereits der Heizleiter 1 und an den ersten Anschlussflächen 5 bereits das Temperaturerfassungselement 3 angeschlossen sind, während dann an den zweiten Anschlussflächen 10 und 11 die jeweiligen Anschlussleiter 19 für den Heizleiter 1 und die Verbindungsleiter 20 für das Temperaturerfassungselement 3, um es mit der Elektronik oder Auswerteeinheit (ECU) 15 zu verbinden, angeschlossen werden.

Ebenfalls ist nicht ausgeschlossen, dass zum Beheizen einer Fläche vor Einbau der Leiterplatte 7 in die Endposition diese an geeigneter Stelle im Bereich der zu beheizenden Fläche positioniert wird, wobei an den zweiten Anschlussflächen 10 bereits die Anschlussleiter 19 für den Heizleiter 1 und an den zweiten Anschlussflächen 11 bereits die Verbindungsleiter 20 für das Temperaturerfassungselement 3, um es mit der Elektronik oder Auswerteeinheit (ECU) 15 zu verbinden, angeschlossen sind. Nach der Endpositionierung der Leiterplatte 7 werden der Heizleiter 1 an dessen Anschlussenden 1a, 1b mit den ersten HL-Anschlussflächen 2 und das Temperaturerfassungselement 3 an dessen Anschlussenden 4a, 4b mit den ersten TE-Anschlussfläche 5 verbunden. Vorteilhaft kann es sein, dass die Leiterplatte 7 das Temperaturerfassungselement 3 vor der Endpositionierung, als SMD-Bauelement bestückt, bereits aufweist.

Zum Beheizen einer Fläche im Innenraum eines Fahrzeugs wird vor Einbau zunächst die Heizeinrichtung mit den Anschlussleitern 19 für den Heizleiter 1 und mit den Verbindungsleitern 20 für das Temperaturerfassungselement 3 über die jeweiligen Anschlussflächen 2, 5, 10, 11 der Leiterplatte 7 verbunden; danach wird die Heizeinrichtung an der zu beheizenden Fläche im Innenraum des Fahrzeugs angebracht. Durch die Leiterplatte 7 sind folglich reproduzierbare Anschlussbedingungen innerhalb des Fahrzeugs für das Heizelement 100, respektive für den Heizleiter 1, das Temperaturerfassungselement 3 sowie die Elektronik oder Auswerteeinheit 15 (ECU), gegeben, so dass diese Vorgänge zumindest teilweise auch automatisiert durchgeführt werden können. Hierzu kann in noch vorteilhafter Weise die Leiterplatte 7 entweder mit Anschluss- oder Verbindungsleitern 19, 20 für die Elektronik oder Auswerteeinheit 15 an den Anschlussflächen 10,11 vorkonfektioniert werden, oder es wird vor dem Einbau der Leiterplatte 7 an ihrem Bestimmungsort zumindest das Temperaturerfassungselement 3 mit seinen Anschlussdrähten 4a, 4b an den Anschlussflächen (erste TE-Anschlussflächen) 5 verbunden und/oder es wird vor dem Einbau der Leiterplatte 7 an ihrem Bestimmungsort zumindest der Heizleiter 1 mit seinen Anschlussenden 1a, 1b (HL-Anschlussenden) an die Anschlussflächen 2 verbunden. Die Elektronik oder Auswerteeinheit 15 ist wiederum mit einer Stromversorgung 14 fahrzeugseitig verbunden.

Ein weiterer, eigenständiger Erfindungsgedanke der erfindungsgemäßen Heizeinrichtung ist darin zu sehen, dass über die Leiterbahnen 12, 13 der Leiterplatte 7 Widerstände zwischen den ersten HL-Anschlussflächen 2 und den zweiten HL-Anschlussflächen 10 und/oder zwischen den ersten TE-Anschlussflächen 5 und den zweiten TE-Anschlussflächen 11 eingestellt werden können, indem die Flächen der Leiterbahnen 12, 13 entsprechend vergrößert oder verkleinert werden, gegebenenfalls auch über eine unterschiedliche Dicke der Leiterbahnen 12, 13. Eine mäanderförmige Geometrie der Leiterbahnen ist ebenso möglich.

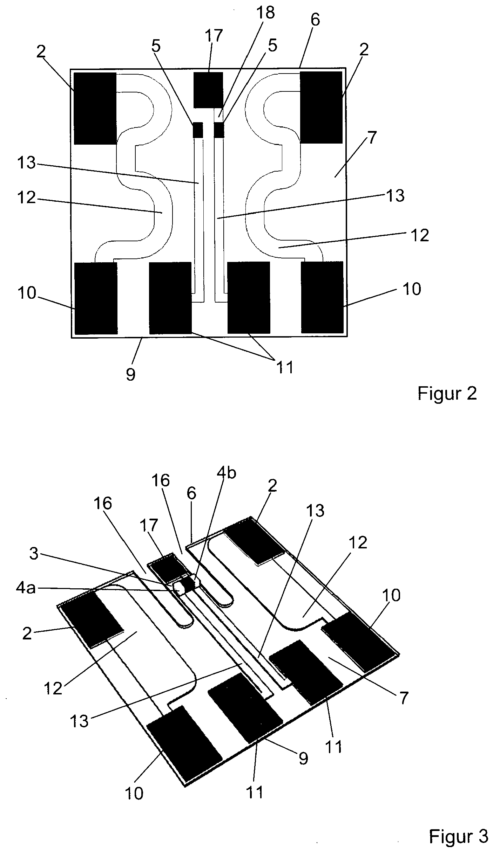

Bevorzugt werden aber die Flächen der Leiterbahnen 12, die zwischen den ersten HL-Anschlussflächen 2 und den zweiten HL-Anschlussflächen 10 für den Heizleiter 1 auf der Leiterplatte 7 vorgesehen sind, größer gewählt als die schmalen, streifenförmigen Leiterbahnen 13, die dem Temperaturerfassungselement 3 zugeordnet sind. Durch diese größere Fläche der Leiterbahnen 12 verringert sich der Widerstand dieser Leiterbahnen 12, mit der Folge, dass durch diese Leiterbahnen 12, je nachdem wie groß der Widerstand eingestellt ist, Wärme erzeugt wird. Diese Wärme wird auf die Leiterbahnen 13 für das Temperaturerfassungselement 3, die zwischen den Leiterbahnen 12 für den Heizleiter 1 verlaufen, übertragen, so dass der Temperaturmesswert, der von dem Temperaturerfassungselement 3 erfasst wird, von der Strahlungswärme oder Wärmeleitung über die Leiterplatte 7 beeinflusst wird. Dies ist insbesondere dann der Fall, wenn das Temperaturerfassungselement 3 sehr nahe an den Anschlussflächen 5 der Leiterplatte 7 oder direkt auf den Leiterbahnen 13 positioniert ist, wie dies in den weiteren Figuren 2 bis 6 dargestellt ist.

Soweit in den verschiedenen Figuren Bauteile, die miteinander vergleichbar sind, mit denselben Bezugszeichen bezeichnet sind, so kann die Beschreibung dieser Bauteile einer Ausführungsform in analoger Weise auf die anderen Ausführungsform(en) übertragen werden, ohne dass diese Bauteile erneut im Detail beschrieben werden. Um die Wärmeübertragung von den Leiterbahnen 12 des Heizleiters 1 auf die Leiterbahnen 13 für das Temperaturerfassungselement 3 oder direkt auf das Temperaturerfassungselement 3 einzustellen, kann der Bereich zwischen der Leiterbahn 12 für den Heizleiter 1 und die dazu benachbarte Leiterbahn 13 für das Temperaturerfassungselement 3 abgetragen oder mit einer Durchbrechung 16 getrennt werden. Diese Durchbrechung 16, oder der Schlitz, ist vorzugsweise zu dem Rand der Platte 8 hin offen. Die Wärmeübertragung kann darüber hinaus durch die Länge und/oder Breite des Schlitzes beeinflusst werden, wie dies anhand der weiteren Figuren dargestellt ist.

Wie ein Vergleich der verschiedenen Figuren zeigt, kann die Größe der Fläche jeder Leiterbahn 12 für den Heizleiter 1 im Bereich von dem Vierfachen, bevorzugter von dem Zehnfachen, und noch bevorzugter von dem Zwanzigfachen, der Größe der Fläche einer Leiterbahn 13 für das Temperaturerfassungselement 3 betragen.

Anhand der Figuren ist weiterhin zu erkennen, dass es bevorzugt ist, die beiden ersten HL-Anschlussflächen 2 und die beiden zweiten HL-Anschlussflächen 10 für den Heizleiter 1 an den Eckpositionen der Platte 8 anzuordnen. Diese Flächen, die als Löt- oder Schweiß- oder Crimpflächen ausgebildet sein können, sind in den Figuren im Verhältnis zu der Gesamtgröße der Leiterplatte 7 vergrößert dargestellt. Die Leiterbahnen 12 für den Heizleiter 1 sind flächenmäßig von der jeweiligen ersten HL-Anschlussfläche 2 und der jeweiligen zweiten HL-Anschlussfläche 10 ausgehend zu den Leiterbahnen 13 für das Temperaturerfassungselement 3 hin ausgedehnt. Die Breite der Leiterbahnen 13 für das Temperaturerfassungselement 3 sollte zwischen 1 und 3 mm betragen; die Dicke der Leiterbahnen 12, 13 sollte im Bereich von 10 bis 140 µm, bevorzugt im Bereich von 35 bis 70 µm, liegen.

Die Figur 1 B zeigt die erfindungsgemäße Heizeinrichtung mit einem schematisch dargestellten Heizelement 100. Dabei sind der Heizleiter 1 und das Temperaturerfassungselement 3 auf einem Trägermaterial 8 aufgebracht. In dieser Ausführungsform ist die Leiterplatte 7 auf dem Trägermaterial 8 angeordnet. Als Trägermaterial 8 können sowohl Textilien, Gewirke, Vliese, Tüllstoffe, Schäume, Zellkautschuk, aber auch Kunststoffe in Form von Folien, verwendet werden. Hierbei ist zu beachten, dass die Leiterplatte 7 in Figur 1 B nur schematisch dargestellt ist. Detailliertere Ausführungen für die Leiterplatte 7 sind in der Figur 1A und den Figuren 2 bis 6 dargestellt. Die Anschlussleiter 19 und Verbindungsleiter 20, die mit den, in dieser Figur 1 B nicht dargestellten, entsprechenden zweiten HL-Anschlussflächen 10 und zweiten TE-Anschlussflächen 11 auf der Leiterplatte 7 verbunden sind, sind mit der ebenfalls in dieser Figur 1 B nicht dargestellten Auswerteeinheit/Elektronik 15 verbunden.

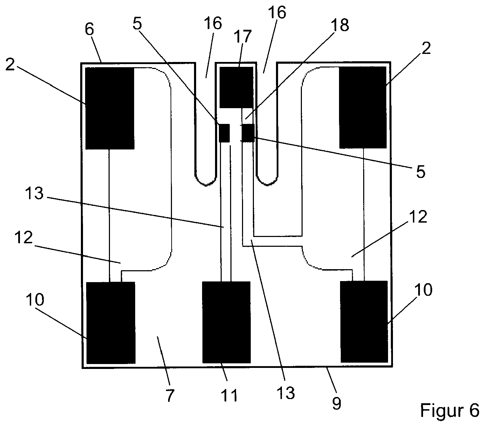

In den Ausführungsformen, wie sie in den Figuren 2 und 6 gezeigt sind, ist die Leiterplatte 7 ohne Temperaturerfassungselement dargestellt, da diese Figuren nur dazu dienen, weitere Ausgestaltungen der Leiterbahnen 12 und 13 der Leiterplatte 7 darzustellen.

In den Ausführungsformen, wie sie in den Figuren 3 bis 5 dargestellt sind, ist das Temperaturerfassungselement 3 als SMD-Bauelement ausgeführt, dessen TE-Anschlussenden 4a, 4b unmittelbar an den ersten TE-Anschlussflächen 5 der Leiterbahnen 13 angebracht sind, so dass die zusätzlichen Anschlussdrähte 4, wie sie in Figur 1 zu sehen sind, entfallen. Darüber hinaus ist bei dieser Anordnung das Temperaturerfassungselement 3 als Bestandteil der Leiterplatte 7 unmittelbar zwischen den Leiterbahnen 12 für den Heizleiter 1 angeordnet und ist dadurch der Wärme ausgesetzt, die durch die Fläche der Leiterbahn 12 erzeugt wird. Da sich der Widerstand der Leiterbahn 12 und damit die hervorgerufene Erwärmung der Leiterbahn 12 mit der Heizleistung des Heizleiters 1 ändert, erfasst das Temperaturerfassungselement 3 die von den Leiterbahnen 12 abgegebene Wärme, die zu der Heiztemperatur des Heizleiters 1 korreliert.

Zusätzlich ist in den Ausführungsformen der Figuren 2 bis 6 im Bereich der Enden der Leiterbahnen 13 für das Temperaturerfassungselement 3 ein Wärmespeicher 17 angeordnet, der von den Leiterbahnen 13 getrennt ist; dieser Wärmespeicher 17 ist gegebenenfalls nur mit einem Leiterbahnabschnitt 18, wie er in den Figuren 2 und 4bis 6 deutlich zu erkennen ist, durch eine TE-Anschlussfläche 5 mit einer der Leiterbahnen 13 verbunden. Bei diesem Wärmespeicher 17 kann es sich um eine Anhäufung eines gut Wärme leitenden Materials, wie beispielsweise Lötzinn, handeln. Alternativ können SMD-Bauelemente mit definierten Wärmekapazitäten, die in thermischen Kontakt mit dem Temperaturerfassungselement 3 stehen, bestückt werden. Dieser Wärmespeicher 17 nimmt die von den Leiterbahnen 12 für den Heizleiter 1 abgegebene Wärme auf und beeinflusst so die Trägheit des Temperaturerfassungselements 3 bei der Temperaturerfassung. Der Wärmespeicher 17 ist an dem Rand der Leiterplatte 7 angeordnet, so dass entsprechend die zwei ersten TE-Anschlussflächen 5 für das Temperaturerfassungselement 3 von dem Rand der Platte 8 beabstandet sind.

Weiterhin ist in der Figur 2 die jeweilige Leiterbahn 12, die mit den ersten HL-Anschlussflächen 2 und den zweiten HL-Anschlussflächen 10 in Verbindung steht, zumindest teilweise mäanderförmig dargestellt.

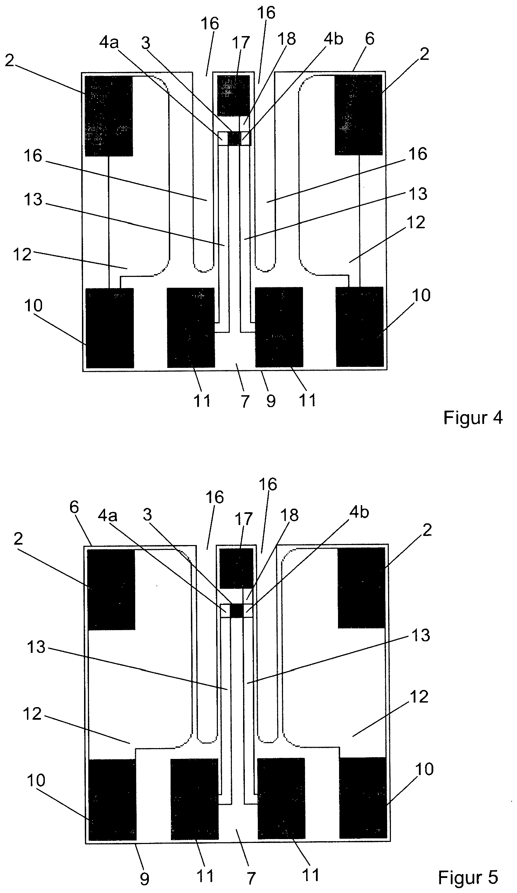

Die Gegenüberstellung der Figuren 4 und 5 verdeutlicht, wie die Fläche der Leiterbahnen 12 für den Heizleiter 1 variiert werden kann. Im Gegensatz zu der Ausführungsform, wie sie in Figur 4 dargestellt ist, füllt die Fläche der jeweiligen Leiterbahn 12 den gesamten Bereich zwischen dem Rand der Platte 8 und der Durchbrechung 16 aus, wodurch der Widerstand dieser Leiterbahn 12 gegenüber dem Widerstand der Leiterbahn 12 der Figur 4 verkleinert wird und die Wärmeeintragung dadurch geringer bleibt.

In Figur 6 ist eine Ausführungsform dargestellt, bei der die eine Leiterbahn 13 für das Temperaturerfassungselement 3 direkt mit der einen Leiterbahn 12 für den Heizleiter 1 verbunden ist, so dass der Anschluss dieser Leiterbahn 13 für das Temperaturerfassungselement 3 über die zweite HL-Anschlussfläche 10 abgegriffen wird. Folglich sind an dem in Figur 6 unteren Rand der Leiterplatte 7 insgesamt zwei zweite HL-Anschlussflächen 10 für den Heizleiter 1 und eine zweite TE-Anschlussfläche 11 für das Temperaturerfassungselement 3 vorhanden.

## Patentansprüche

1. Heizeinrichtung zum Beheizen von Flächen im Innenraum eines Fahrzeugs mit mindestens einem Heizelement (100), das mindestens einen Heizleiter (1), der einen elektrischen Heizkreis bildet, und mindestens ein Trägermaterial (8) aufweist, wobei der Heizleiter (1) durch das Trägermaterial (8) gehalten ist, und mit einem Temperaturerfassungselement (3), wobei der Heizleiter (1) mindestens zwei HL-Anschlussenden (1a, 1b) und das Temperaturerfassungselement (3) mindestens zwei TE-Anschlussenden (4a, 4b) aufweisen, wobei die zwei HL-Anschlussenden (1a, 1b) jeweils mit einer HL-Anschlussfläche (2) verbunden sind und die zwei TE-Anschlussenden (4a, 4b) jeweils mit einer TE-Anschlussfläche (5) verbunden sind, wobei die Anschlussflächen (2, 5) auf einer Leiterplatte (7) angeordnet sind und die Leiterplatte (7) auf, unter oder an dem mindestens einen Trägermaterial (8) angeordnet ist, **dadurch gekennzeichnet, dass** mindestens die zwei HL-Anschlussenden (1a, 1b) mit jeweils einer ersten HL-Anschlussfläche (2) der Leiterplatte (7) elektrisch verbunden sind und die zwei TE-Anschlussenden (4a, 4b) mit jeweils einer ersten TE-Anschlussfläche (5) der Leiterplatte (7) elektrisch verbunden sind, und die Leiterplatte (7) zwei zweite HL-Anschlussflächen (10) und mindestens eine zweite TE-Anschlussfläche (11) aufweist, wobei die ersten HL-Anschlussflächen (2) und die zweiten HL-Anschlussflächen (10) zumindest teilweise mittels erster Leiterbahnen (12) und die eine erste TE-Anschlussfläche (5) und/oder die andere der zwei ersten TE-Anschlussflächen (5) jeweils mittels einer zweiten Leiterbahn (13) mit einer zweiten TE-Anschlussfläche (11) verbunden sind,
dass die zweiten Leiterbahnen (13), die den ersten und zweiten TE-Anschlussflächen (5, 11), mit denen das Temperaturerfassungselement (3) verbunden ist, zwischen den zwei ersten Leiterbahnen (12), die den ersten und zweiten HL-Anschlussflächen (2, 10), mit denen der Heizleiter (1) verbunden ist, verlaufen und
dass mindestens zwei der ersten und zweiten Leiterbahnen (12, 13) der Leiterplatte (7) über deren Abstand zueinander und/oder durch Abtragung des Materials der Leiterplatte (7) und/oder durch Durchbrechung (16) in der Leiterplatte (7) und/oder durch Auswahl des Materials der Leiterplatte (7) eine definierte thermische Kopplung aufweisen.

2. Heizeinrichtung nach Anspruch 1, **dadurch gekennzeichnet, dass** durch den Verlauf der ersten Leiterbahnen (12), die den Heizleiter (1) mit Heizleiterstrom versorgen, und durch Einstellung der Breite der ersten Leiterbahnen (12) die durch diese ersten Leiterbahnen (12) erzeugte Wärmeleistung eingestellt wird.

3. Heizeinrichtung nach einem der Ansprüche 1 oder 2, **dadurch gekennzeichnet, dass** das Temperaturerfassungselement (3) als unbedrahtetes, mit TE-Anschlussenden (4a, 4b) versehenes SMD-Bauelement ausgebildet ist und unmittelbar auf den TE-Anschlussflächen (5) der Leiterplatte (7) aufgebracht ist.

4. Heizeinrichtung nach einem der Ansprüche 1 bis 3, **dadurch gekennzeichnet, dass** das Temperaturerfassungselement (3) thermisch mit einem Wärmespeicher (17) aus einem Wärme speichernden Material gekoppelt ist.

5. Heizeinrichtung nach Anspruch 4, **dadurch gekennzeichnet, dass** der Wärmespeicher (17) ein SMD-Bauelement ist, welches über mindestens einen Leiterbahnabschnitt (18) auf der Leiterplatte thermisch mit dem Temperaturerfassungselement (3) gekoppelt ist.

6. Heizeinrichtung nach einem der Ansprüche 1 bis 5, **dadurch gekennzeichnet, dass** im Bereich des Temperaturerfassungselements (3) zwischen der jeweiligen zweiten Leiterbahn (13) für das Temperaturerfassungselement (3) und der jeweils benachbarten ersten Leiterbahn (12) für den Heizleiter (1) Material der Leiterplatte (7) abgetragen ist.

7. Heizeinrichtung nach Anspruch 6, **dadurch gekennzeichnet, dass** die Leiterplatte (7) derart abgetragen ist, dass sie eine Durchbrechung (16) aufweist.

8. Heizeinrichtung nach Anspruch 7, **dadurch gekennzeichnet, dass** die Durchbrechung (16) zum Rand (6) der Leiterplatte (7) hin offen ist.

## Claims

1. Heating device for heating areas in the passenger compartment of a vehicle having at least one heating element (100) comprising at least one heating conductor (1) forming an electric heating circuit, and at least one carrier material (8), wherein the heating conductor (1) is held by the carrier material (8), and having a temperature acquisition element (3), wherein the heating conductor (1) has at least two HC terminal ends (1a, 1b) and the temperature acquisition element (3) has at least two TA terminal ends (4a, 4b), wherein the two HC terminal ends (1a, 1b) are connected to a respective HC terminal area (2) and the two TA terminal ends (4a, 5b) are connected to a respective TA terminal area (5), wherein the terminal areas (2, 5) are arranged on a printed circuit board (7) and the printed circuit board (7) is arranged on, under or at the at least one carrier material (8), **characterized in that** at least the two HC terminal ends (1a, 1b) are electrically connected to a respective first HC terminal area (2) of the printed circuit board (7), and the two TA terminal ends (4a, 4b) are electrically connected to a respective first TA terminal area (5) of the printed circuit board (7), and the printed circuit board (7) has two second HC terminal areas (10) and at least one second TA terminal area (11), wherein the first HC terminal areas (2) and the second HC terminal areas (10) are connected at least partially by way of first conductor paths (12) and the one first TA terminal area (5) and/or the other of the two first TA terminal areas (5) respectively by way of a second conductor path (13) to a second TA terminal area (11),
that the second conductor paths (13) at the first and second TA terminal areas (5, 11) with which the temperature acquisition element (3) is connected run between the two first conductor paths at the first and second HC terminal areas (2, 10) with which the heating conductor (1) is connected, and
that at least two of the first and second conductor paths (12, 13) of the printed circuit board (7) have a defined thermal coupling by their distance to each other and/or by removal of the material of the printed circuit board (7) and/or by penetration (16) in the printed circuit board (7) and/or by selection of the material of the printed circuit board (7).

2. Heating device according to claim 1, **characterized in in that** by the run of the first conductor paths (12) which supply the heating conductor (1) with heating conductor current, and by adjustment of the width of the first conductor paths (12) the heating power generated by said first conductor paths (12) is set.

3. Heating device according to any one of claims 1 or 2, **characterized in that** the temperature acquisition element (3) is configured as a non-wired SMD component provided with TA terminal ends (4a, 5b) and is applied directly to the TA terminal areas (5) of the printed circuit board (7).

4. Heating device according to any one of claims 1 zo 3, **characterized in that** the temperature acquisition element (3) is thermally coupled with a heat store (17) made of a heat-storing material.

5. Heating device according to claim 4, **characterized in that** the heat store (17) is an SMD component that is thermally coupled with the temperature acquisition element (3) via at least one conductor path section (18) on the printed circuit board.

6. Heating device according to any one of claims 1 to 5, **characterized in that**, in the area of the temperature acquisition element (3), material of the printed circuit board (7) is removed between the respective second conductor path (13) for the temperature acquisition element (3) and the respectively adjacent first conductor path (12) for the heating conductor (1).

7. Heating device according to claim 6, **characterized in that** the printed circuit board (7) is cut away such that it has a penetration (16).

8. Heating device according to claim 7, **characterized in that** the penetration (16) is open towards the edge (6) of the printed circuit board (7).

## Revendications

1. Dispositif de chauffage pour chauffer des surfaces dans l'habitacle d'un véhicule, comprenant au moins un élément chauffant (100), qui comporte au moins un conducteur chauffant (1) formant un circuit chauffant électrique, et au moins un matériau de support (8), dispositif dans lequel le conducteur chauffant (1) est maintenu par le matériau de support (8), dans lequel il est prévu un élément de capteur de température (3), dans lequel le conducteur chauffant (1) comporte au moins deux extrémités de connexion de conducteur chauffant dites extrémités de connexion HL (1a, 1b), et l'élément de capteur de température (3) comporte au moins deux extrémités de connexion d'élément de capteur de température dites extrémités de connexion TE (4a, 4b), dans lequel les deux extrémités de connexion HL (1a, 1b) sont reliées respectivement à une surface de connexion de conducteur chauffant dite surface de connexion HL (2), et les deux extrémités de connexion TE (4a, 4b) sont reliées respectivement à une surface de connexion d'élément de capteur de température dite surface de connexion TE (5), dans lequel les surfaces de connexion (2, 5) sont agencées sur une plaque de circuit imprimé (7), et la plaque de circuit imprimé (7) est agencée au-dessus, en-dessous ou sur ledit au moins un matériau de support (8),
**caractérisé**
**en ce qu'**au moins les deux extrémités de connexion HL (1a, 1b) sont reliées respectivement, sur le plan électrique, à une première surface de connexion HL (2) de la plaque de circuit imprimé (7), et les deux extrémités de connexion TE (4a, 4b) sont reliées respectivement, sur le plan électrique, à une première surface de connexion TE (5) de la plaque de circuit imprimé (7), et la plaque de circuit imprimé (7) présente deux deuxièmes surfaces de connexion HL (10) et au moins une deuxième surface de connexion TE (11), les premières surfaces de connexion HL (2) et les deuxièmes surfaces de connexion HL (10) étant reliées au moins partiellement au moyen de premières pistes conductrices (12), et une première surface de connexion TE (5) et/ou l'autre des deux premières surfaces de connexion TE (5) sont reliées respectivement au moyen d'une deuxième piste conductrice (13) à une deuxième surface de connexion TE (11), en ce que les deuxièmes pistes conductrices (13), qui sont associées aux premières et deuxièmes surfaces de connexion TE (5, 11) avec lesquelles est relié l'élément de capteur de température (3), s'étendent entre les deux premières pistes conductrices (12), qui sont associées aux premières et deuxièmes surfaces de connexion HL (2, 10) avec lesquelles est relié le conducteur chauffant (1), et en ce qu'au moins deux des premières et deuxièmes pistes conductrices (12, 13) de la plaque de circuit imprimé (7) présentent un couplage thermique défini, par l'intermédiaire de leur distance d'espacement réciproque et/ou par une érosion de matériau de la plaque de circuit imprimé (7) et/ou par des évidements traversants (16) dans la plaque de circuit imprimé (7) et/ou par le choix du matériau de la plaque de circuit imprimé (7).

2. Dispositif de chauffage selon la revendication 1, **caractérisé en ce que** grâce à la configuration de cheminement des premières pistes conductrices (12), qui alimentent le conducteur chauffant (1) en courant de conducteur chauffant, et grâce au réglage de la largeur des premières pistes conductrices (12), on règle la puissance de chauffe engendrée par ces premières pistes conductrices (12).

3. Dispositif de chauffage selon l'une des revendications 1 ou 2, **caractérisé en ce que** l'élément de capteur de température (3) est réalisé sous la forme d'un composant non câblé, du type SMD (composant monté en surface), muni d'extrémités de connexion TE (4a, 4b), et est rapporté directement sur les surfaces de connexion TE (5) de la plaque de circuit imprimé (7).

4. Dispositif de chauffage selon l'une des revendications 1 à 3, **caractérisé en ce que** l'élément de capteur de température (3) est couplé thermiquement à un accumulateur de chaleur (17) en un matériau accumulant la chaleur.

5. Dispositif de chauffage selon la revendication 4, **caractérisé en ce que** l'accumulateur de chaleur (17) est un composant SMD, qui est couplé thermiquement à l'élément de capteur de température (3) par l'intermédiaire d'au moins un tronçon de piste conductrice (18) sur la plaque de circuit imprimé.

6. Dispositif de chauffage selon l'une des revendications 1 à 5, **caractérisé en ce que** dans la zone de l'élément de capteur de température (3), du matériau de la plaque de circuit imprimé (7) est érodé entre la deuxième piste conductrice (13) respective destinée à l'élément de capteur de température (3), et la première piste conductrice (12) respectivement voisine destinée au conducteur chauffant (1).

7. Dispositif de chauffage selon la revendication 6, **caractérisé en ce que** la plaque de circuit imprimé (7) est érodée de manière à présenter un évidement traversant (16).

8. Dispositif de chauffage selon la revendication 7, **caractérisé en ce que** l'évidement traversant (16) est ouvert vers le bord (6) de la plaque de circuit imprimé (7).
